**Europäisches Patentamt**

**European Patent Office**

**Office européen des brevets**

(19)

(11) Veröffentlichungsnummer: **0 081 830**

**B1**

(12)

# EUROPÄISCHE PATENTSCHRIFT

(45) Veröffentlichungstag der Patentschrift:
23.07.86

(21) Anmeldenummer: **82111477.4**

(22) Anmeldetag: **10.12.82**

(51) Int. Cl.⁴: **G 03 F 7/16**

(54) **Verfahren und Vorrichtung zum Auftragen einer Beschichtung auf dünne, steife Platten.**

(30) Priorität: **15.12.81 DE 3149588**

(43) Veröffentlichungstag der Anmeldung:
**22.06.83 Patentblatt 83/25**

(45) Bekanntmachung des Hinweises auf die Patenterteilung:
**23.07.86 Patentblatt 86/30**

(84) Benannte Vertragsstaaten:
**AT BE CH DE FR GB IT LI NL SE**

(56) Entgegenhaltungen:
**FR-A-2 095 074**
**NL-A-6 509 264**

(73) Patentinhaber: **Howaldtswerke- Deutsche Werft Aktiengesellschaft Hamburg und Kiel, Schwentinestrasse, D-2300 Kiel 14 (DE)**

(72) Erfinder: **Knigge, Rolf, Am Klingenberg 35, D-2000 Hamburg 55 (DE)**
Erfinder: **Albien, Wolfgang, Ohekoppel 36, D-2080 Pinneberg (DE)**

(74) Vertreter: **Hansmann, Dierk, Dipl.- Ing., Jessenstrasse 4, D-2000 Hamburg 50 (DE)**

EP 0 081 830 B1

LIBER, STOCKHOLM 1986

## Beschreibung

Die Erfindung bezieht sich auf ein Verfahren und eine Vorrichtung zum Auftragen einer dünnen Beschichtung auf dünne, steife Platten. Sie betrifft insbesondere das Auftragen eines Fotolacks oder flüssigen Fotoresistmaterials auf das plattenförmige Grundmaterial bei der Herstellung von Leiterplatten.

Üblicherweise werden Bahnen und Platten mittels horizontal angeordneten Auftragswalzen (DE-B-1 804 785) oder Schlitzdüsen beschichtet und durchlaufen auch die Trocknungszone in horizontaler Stellung. Dies setzt aber voraus, daß die Bahnen oder Platten von unten durch Rollen, Tragestangen oder Luftdüsen (DE-B-29 11 685, DE-A-24 33 545) ausreichend unterstützt werden können. Diese Möglichkeit ist bei etwa gleichzeitig beiderseitig beschichteten Leiterplatten nicht mehr gegeben, wenn eine zur Unterstützung oder Halterung verwendbare, unbeschichtete Randleiste sehr schmal ist. Man hat daher bisher die in horizontaler Stellung beiderseitig beschichteten Platten von Hand aus der Beschichtungsvorrichtung entnommen und in Kästen mit Halterungsnuten eingesetzt, bis die Beschichtungen wenigstens oberflächig getrocknet waren. Bei horizontaler Bewegung von seitlich geführten Leiterplatten muß außerdem damit gerechnet werden, daß die Beschichtungen, die gleichzeitig auf beide Seiten aufgebracht werden, und deren Trocknung ungleich ausfällt, und daß sich trotz der Arbeit in einem weitgehend staubfrei gehaltenen Raum wenigstens auf der Oberseite Staubpartikel absetzen, die die Leiterplatten unbrauchbar machen.

Aus NL-A-65 09 264 ist es bekannt, eine Materialbahn aus Metall zu behandeln, die in horizontaler Richtung durch mehrere Behandlungsstellen zu führen, wobei die Bahn vertikal gehalten wird und auf ihrem einen Rand steht. Hierbei kann eine lichtempfindliche Schicht auf beiden Seiten der Materialbahn aufgetragen und gehärtet werden sowie die Bahn danach mit einem fotografischen Abdruck versehen und anschließend geätzt werden. Der lichtempindliche Lack wird am oberen Rand der Bahn aufgebracht und fließt über die vertikalen Oderflächen nach unten, während die Bahn zum Trockenofen läuft. Die Zu- und Abführung der Bahn erfolgt kontinuierlich. Der Abdruck erfordert jedoch einen vorübergehenden Stillstand, der durch Ausgleichseinrichtungen mit vertikalen Umlenkwalzen ermöglicht wird. Diese Vorrichtung setzt eine zusammenhängende Bahn aus einem biegsamen Material voraus. Sie ist daher für die Behandlung einzelner, steifer Platten nicht geeignet. FR-B-2 095 074 zeigt eine Vorrichtung zur beiderseitigen Belichtung beschichteter Leiterplatten, bei der die Platten auf Rahmen angebracht sind, die an eine kontinuierlich umlaufende Förderkette gehängt werden. Die Verwendung von Rahmen ist unzweckmäßig, wenn eine Beschichtung auf sehr dünne Platten aufgetragen werden soll.

Es ist die Aufgabe der Erfindung, ein Verfahren und eine Vorrichtung zur Beschichtung von dünnen, steifen Platten zu schaffen, das auch für die Platten mit einer schmalen Rand- oder Referenzleiste an einer Plattenkante geeignet ist, bei dem die Beschichtung und die Trocknung und Aushärtung in höherem Maße gleichmäßig, insbesondere auf beiden Seiten der Platten erfolgt und wobei zugleich die beschichteten Platten weniger dem Staubbefall ausgesetzt sein sollen. Die Vorrichtung soll außerdem auch für Platten unterschiedlicher Abmessungen verwendbar sein.

Zur Lösung dieser Aufgabe ist bei einem Verfahren zum Auftragen einer Beschichtung auf eine Mehrzahl dünner, steifer Platten mittels Auftragswalzen und bei einem Transport der Platten hintereinander kontinuierlich in horizontaler Richtung durch wenigstens eine Auftragsstation und eine anschließende Trocknungszone vorgesehen, daß die Platten in eine lotrechte Stellung gebracht und in dieser Stellung an einer zur Transportrichtung parallelen Referenzleiste, die sich entlang eines Randes jeder Platte erstreckt, zum Zwecke des Transports festgehalten werden und daß an jeder Stelle des Weges der Platten Druck und Erwärmung auf die beiden vertikalen Oberflächen der Platten von beiden Seiten des Weges symmetrisch wirken. Vorzugsweise befinden sich die Oberflächen aufeinanderfolgender Platten beim Durchlaufen der Auftragsstation und der Trocknungszone in derselben Ebene.

Zweckmäßigerweise werden die Platten hängend gehalten, wobei Greifer an einem oberhalb des Weges der Platten umlaufenden Transportmittel an den Referenzleisten der Platten angreifen. Der bevorzugte kontinuierliche Transport der Platten in lotrechter Stellung und in horizontaler Richtung ermöglicht eine gleichmäßige Behandlung beider Seiten jeder Platte und ergibt auch bei nur einseitg beschichteten Platten eine konstante Qualität der Schicht sowohl auf einer Platte als auch auf verschiedenen Platten..

In einer bevorzugten Ausführung durchlaufen die Platten die Auftragsstation und die Trocknungszone stehend. In diesem Falle ist ein Transportmittel, vorzugsweise eine mit zangenförmigen Greifern versehene Transportkette unterhalb des Weges der Platten angeordnet. Die Referenzleiste befindet sich bei dieser Ausführung an der unteren Kante der Platten und wird von den Greifern unterstützt und so gehalten, daß die Platten in lotrechter Stellung stehen. Diese Ausführung hat den Vorteil, daß sich oberhalb der Platten keine Transportmittel befinden, von denen Schmutz auf die Platten fallen könnte.

In der Auftragsstation laufen die Platten zwischen wenigstens zwei Walzen mit elastischen Oberflächen hindurch. Hiervon ist wenigstens eine eine Auftragswalze. Bei beiderseitiger Beschichtung befindet sich an jeder Seite eine Auftragswalze. Die Achsen der Walzen sind ebenfalls lotrecht.

Eine geeignete Auftragswalze und ihre Verwendung zum Aufbringen einer lichtempfindlichen Schicht auf eine Leiterplatte mit durchgehenden Löchern, die von der Beschichtung nicht bedeckt werden, ist in DE-AS 1 804 785 beschrieben. Diese bekannte Auftragswalze hat eine Oberfläche mit elastisch deformierbaren Vertiefungen, z. B. in Form von Gewindegängen, in denen die Beschichtungsmasse zunächst aufgenommen und aus denen die Beschichtungsmasse beim Andrücken der Walze an die Platte abgegeben wird. Diese Auftragswalzen wurden jedoch bisher nur horizontal, für beiderseitige Beschichtung oberhalb und unterhalb der Platten angeordnet. Andere als die in DE-AS 1 804 785 bekannten Walzen können jedoch zweckmäßig sein, z. B. wegen der vertikalen Anordnung der Walzen oder der Art der aufzubringenden Schichten.

Für das Auftragen der Beschichtung auf lotrecht hängende oder stehende Platten sind erfindungsgemäß jedoch die Auftragswalzen lotrecht angeordnet, was auch eine von DE-AS 1 804 785 abweichende Zuführung der Beschichtungsmasse an die Auftragswalze erfordert. Hierfür ist eine Düse mit einem lotrechten, sich über die Länge der Auftragswalze erstreckenden Abgabeschlitz vorgesehen. Der Schlitz ist einstellbar, und die Düsenlippen beiderseits des Schlitzes werden unter leichter vorübergehender, örtlicher Verformung der elastischen Oberfläche an die Auftragswalze angedrückt, wobei die in der Drehrichtung der Walze zweite Düsenlippe zugleich als Rakel wirkt und mit einer Abreißkante versehen sein kann. Weitere Rakel, Abquetschwalzen u. ä. sind nicht notwendig. Um die Menge der zuzuführenden Beschichtungsmasse zu regulieren, ist der Druck der Beschichtungsmasse in der Düse veränderlich und außerdem kann auch die Kraft, mit der die Düse an die Oberfläche der Walze angedrückt wird, eingestellt werden.

Die Breite der Auftragswalze ist gleich der größten vorkommenden Breite bzw. Höhe der Platten. Bei kleineren Platten wird aus einem Teil der Vertiefungen in der Oberfläche der gegen die Platten gedrückten Auftragswalzen keine Beschichtungsmasse abgegeben, und wenn dieser Teil wieder an die Abgabeschlitze gelangt, kann in die noch gefüllten Vertiefungen keine weitere Beschichtungsmasse abgegeben werden. Dasselbe geschieht, wenn zwischen aufeinanderfolgenden Platten Abstände entstehen oder über einen längeren Zeitraum keine weiteren Platten in die Vorrichtung eingesetzt werden. In diesen Fällen verschließt die Auftragswalze den Abgabeschlitz.

Falls nur eine einseitige Beschichtung gewünscht wird, kann gegenüber der Auftragswalze eine gleiche Walze, der jedoch keine Beschichtungsmasse zugeführt wird, angeordnet sein.

In der Trocknungszone sind beiderseits des Weges der stehend oder hängend transportierten Platten Düsen für ein trocknendes, gasförmiges Medium in spiegelbildlicher Anordnung angebracht, so daß die Wirkung der Strömungen auf beiden Seiten der Platten gleich ist, wodurch außerdem die Stellung der Platten stabilisiert wird und bei beiderseitiger Beschichtung auf beiden Seiten in gleicher Weise das Lösungsmittel entfernt wird. In der Trocknungszone können außerdem noch Infrarot-Wärmestrahler ebenfalls in spiegelbildlicher Ausführung vorgesehen sein Infolge der lotrechten Stellung der Platten erfolgen Trocknung, Aushärtung und Kühlung auf beiden Seiten gleichmäßig und gleichzeitig.

Die vorzugsweise in der Vorrichtung zu beschichtenden Grundplatten für Leiterplatten haben z. B. eine Fläche von etwa 145 x 185 mm bis 360 x 600 mm bei einer Dicke von 0,2 bis 4 mm und bestehen beispielsweise aus mit Melaminharz imprägniertem Papier oder aus glasfaserverstärktem Epoxydharz und sind meist beidseitig mit einer dünnen Kupferschicht bedeckt, auf die der Fotolack aufzutragen ist. Die Platten sind häufig mit einer Vielzahl kleiner Löcher versehen, die durch die Beschichtung nicht ausgefüllt oder verdeckt werden dürfen. Es wird eine Dicke der getrockneten Schicht von etwa 4 µm bis 8 µm angestrebt, jedoch können auch noch dünnere Schichten vorkommen und dickere Schichten sind nicht ausgeschlossen. Die Platten besitzen an einer Kante eine als Referenzleiste bezeichnete Halterungszone, an der sie während der weiteren Bearbeitung ausgerichtet werden und an der sie in der Beschichtungsanlage erfaßt werden können. Bei stehend transportierten Platten sollte sich die Referenzleiste möglichst an einer langen Kante befinden. Es wird eine sehr schmale Referenzleiste angestrebt, die möglichst nicht breiter als 10 mm und frei von der Beschichtungsmasse sein sollte. Die Platten sind verhältnismäßig biegesteif, lassen sich aber an der schmalen Referenzleiste nicht mehr ohne die Gefahr einer Beschädigung oder einer ungleichmäßigen Behandlung infolge von Verbiegungen in waagerechter Stellung festhalten. Das erfindungsgemäße Auftragen der Beschichtung und die Trocknung in lotrechter Stellung ermöglichen auch die gleichmäßige Behandlung verhältnismäßig großer Platten mit schmalen Referenzleisten und die abwechselnde Bearbeitung von großen und kleinen Platten. Sie verhindern außerdem weitgehend das Absetzen von Staubpartikeln, die in dem Behandlungsraum absinken. Die kontinuierliche Behandlung in gegenüber der Raumluft abgeschlossenen aufeinanderfolgenden Kammern, in die eine stetige Zufuhr von besonders staubfrei gemachter Reinluft erfolgt, trägt zusätzlich dazu bei, ein Absetzen von Staub auszuschließen, welcher die Leiterplatten unbrauchbar macht.

Der zur Beschichtung von Leiterplatten verwendete Fotolack wird nach Erwärmung oder Kühlung mit einer Temperatur von z. B. 20 bis 22°C aufgetragen. In der Trocknungszone wird das in dem Fotolack enthaltene Lösungsmittel durch Anblasen von Luft von etwa 40 bis 70°C entfernt

u..d gleichzeitig erfolgt die Erwärmung des trocknenden Fotolacks durch Infrarotstrahler. Danach kann gegebenenfalls eine weitere Beschichtung mit Fotolack und eine erneute Trocknung erfolgen. Zur Aushärtung wird die Beschichtung insbesondere durch Strahler auf etwa 95° C erhitzt. Während der Trocknung und Aushärtung erfolgt in der Beschichtung eine von der Behandlungszeit abhängige Vernetzung, die bei der weiteren Bearbeitung die optimale Beschichtungszeit und die Vorgänge beim Ätzen der Platten usw. bestimmt. Die erfindungsgemäß kontinuierlich und gleichförmig durchgeführte Behandlung der Platten in der Vorrichtung schafft daher günstige Voraussetzungen für deren weitere Bearbeitung und vermindert den dabei entstehenden Ausschuß.

Weitere Einzelheiten werden anhand der auf den schematischen Zeichnungen dargestellten Ausführungsbeispiele beschrieben. Es zeigen

Figur 1 eine Seitenansicht einer Vorrichtung, in der die Platten hängend behandelt werden, wobei eine Seitenwand der Behandlungskammern entfernt ist,

Figur 2 einen horizontalen Schnitt durch eine Auftragsvorrichtung, die für beidseitige Beschichtung verwendet werden kann,

Figur 3 eine Seitenansicht auf den unteren Teil einer Auftragsvorrichtung nach Figur 2,

Figur 4 eine Seitenansicht einer Vorrichtung bei der die Förderkette unterhalb der Platten verläuft und die Platten stehend behandelt werden,

Figur 5 einen Greifer an einer Förderkette, die unterhalb der Platten verläuft, in einem Schnitt durch einen Teil der Aufnahmestation.

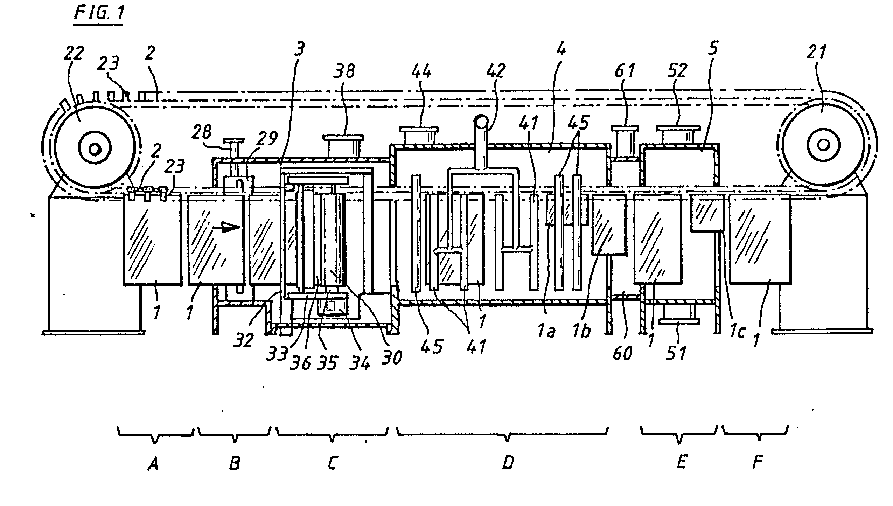

Die Vorrichtung gemäß Figur 1 umfaßt eine Aufnahmestation A, eine Entstaubungsstation B, eine Auftragsstation C, eine Trocknungszone D, eine Kühlzone E und eine Abgabestation F. Durch die Zonen A bis E läuft ein Trumm einer Förderkette 2, an der die Platten 1, 1a, 1b, 1c hängend festgehalten werden. Die Entstaubungsstation B und die Auftragsstation C sind in einer ersten Kammer 3 angeordnet. Die Trocknungszone D befindet sich in einer Kammer 4 und die Kühlzone E in einer weiteren Kammer 5.

Die Förderkette 2 läuft über ein Antriebsrad 21, das von einem nicht dargestellten Motor regelbar angetrieben ist, und über ein Umlenkrad 22. An der Förderkette 2 sind Greifer 23 zum Halten der Platten 1 angebracht. Bei dem in Figur 1 dargestellten Ausführungsbeispiel läuft die Förderkette 2 oberhalb des Weges der Platten 1, und die Platten 1 werden hängend transportiert, wobei ihre oben befindlichen Referenzleisten von den Greifern 23 erfaßt sind.

In der Aufnahmestation A werden die gereinigten Platten 1 von Hand oder mittels einer geeigneten Vorrichtung in die Greifer 23 eingesetzt.

In der Entstaubungsstation B wird der möglicherweise noch an den Platten 1 haftende Staub aufgewirbelt, mittels Ionisierungsstäben ionisiert und durch ein Saugrohr 29 und eine Leitung 28 weggeführt. In der Auftragsstation C ist an jeder Seite der Platten 1 eine Auftragswalze 30 angeordnet, die eine elastische Oberfläche beispielsweise aus Gummi besitzt. In dieser Oberfläche befinden sich kleine Vertiefungen, die elastisch verformbar sind, vorzugsweise in Form von Gewindegängen. Die Walzen 30 werden in einem Rahmen 32 an die kontinuierlich vorbeigeführten Platten 1 angedrückt. Die Walzen 30 sind durch Motore 34 regelbar angetrieben und besitzen lotrechte Achsen 35. An jeder Walze 30 ist eine Düse 38 angeordnet, die den Auftragswalzen 30 die Beschichtungsmasse zuführt. Die Düse 38 ist ebenfalls lotrecht angebracht und reicht über die ganze Breite der Walze 30. Die Beschichtungsmasse wird der Düse 38 von einer nicht dargestellten Pumpe zugeführt. Einrichtungen zur Regelung des Druckes und der Temperatur der flüssigen Beschichtungsmasse sind nicht gezeigt.

In der Trocknungszone D ist eine Vielzahl von Luftdüsen 41 beiderseits der Platten 1 angeordnet, die warme Luft- oder Gasströme gleismäßig von beiden Seiten gegen die Platten 1 blasen und die Beschichtungsmasse trocknen. Außerdem sind beiderseits der Platten Infrarotstrahler 45 vorgesehen.

In die Kammer 3 wird über das Luftzuleitungsrohr 38 besonders staubfreie Reinluft eingeleitet, so daß in ihr ein leichter Überdruck gegenüber der Raumluft und der Kammer 4 herrscht. Ebenso wird in eine Übergangskammer 80 über eine Zuleitung 81 Reinluft mit leichtem über druck zugeführt. Aus der Kammer 3 und der übergangskammer 80 strömt Reinluft in die Trocknungszone D ein. In dieser wird die trockene Luft durch nicht dargestellte Ventilatoren umgewälzt, gegebenenfalls erwärmt oder gekühlt und über Leitungen 42 den Luftdüsen 41 zugeführt. Aus der Kammer 4 wird ständig eine gewisse Menge der sich mit Lösungsmitteln anreichernden Trocknungsluft über das Rohr 44 abgeführt, so daß in der Kammer ein etwas niedrigerer Druck als in den benachbarten Kammern 3 und 80 herrscht, aus denen Luft durch die öffnungen für den Transport der Platten 1 in die Kammer 4 nachströmt. Der Kammer 5 wird kalte oder Raumluft zur Abkühlung der getrockneten und gegebenenfalls auch ausgehärteten Platten über das Rohr 51 zugeführt, die über das Rohr 52 und durch die öffnungen in den Kammerwänden für den Transport der Platten entweicht.

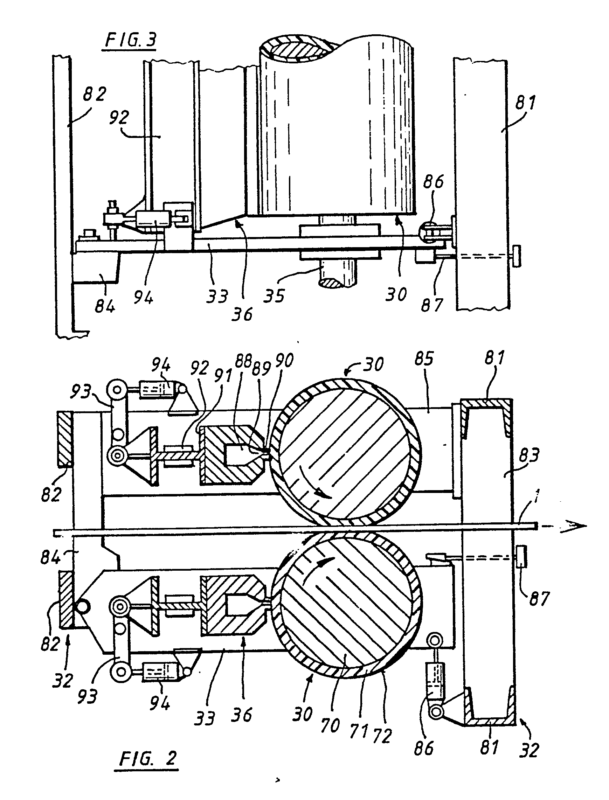

In Figur 2 und 3 sind weitere Einzelheiten der Auftragsstation C gezeigt. Der Rahmen 32 besteht aus Ständern 81, 82 und Querträgern 83, 84. An einer Seite des Weges einer Platte 1 erstreckt sich ein Längsträger 85 zwischen den auerträgern 83, 84. An ihm befindet sich ein Lager für eine Auftragswalze 30. An der anderen Längsseite ist ein Schwenkhebel 33 drehbar an dem Querträger 84 gelagert. Auf ihm befindet sich die zweite Auftragswalze 30, die durch einen pneumatischen Zylinder 88 an die Platte 1 bzw. gegen die andere Walze 30 gedrückt wird. Eine Stellschraube 87 begrenzt die Bewegung des Schwenkhebels 33,

um einen Spalt zwischen den Walzen entsprechend der Dicke der Platten 1 einzustellen.

Die Auftragswalzen 30 bestehen aus einem Kern 70 aus einem festen Material wie z. B. Stahl und einer elastischen Schicht 71 aus Gummi oder Ähnlichem Material. Die Äußere Oberfläche 72 der Auftragswalzen 30 ist mit kleinen Vertiefungen oder Rillen versehen, vorzugsweise in Form von Gewindegängen. In einem ausgeführten Beispiel war der Durchmesser des Kerns 138 mm, die Dicke der verformbaren Schicht 71 betrug etwa 12 mm, und es waren etwa 18 Gewindegänge pro 10 mm Länge der Walze etwa 0,2 mm tief in die Oberfläche 72 eingeschnitten. Diese Auftragswalze wurde zum Aufbringen eines Fotolacks verwendet, dessen Schicht nach dem Trocknen 0,008 mm dick war. Für andere Beschichtungen können andere Auftragswalzen zweckmäßig sein.

Als Düse 36 wird eine Schlitzdüse 88 vertikal und parallel zu jeder Auftragswalze 30 angeordnet. Sie ist gegen die Oberfläche 72 der Walze 30 beweglich, die den Schlitz 89 verschließt, so daß die Beschichtungsmasse nur in die Vertiefungen der verformbaren Oberfläche 72 abgegeben wird. Die Lippen 90 der Düse 88 bleiben mit der elastischen Oberfläche 72 in Kontakt und wirken als Rakel, um die Menge der an die Auftragswalze abgegebenen Beschichtungsmasse zu begrenzen. Die Düsen 38 bzw. 88 sind an vertikalen Trägern 91 angeordnet, die in Führungen 92 beweglich sind, und können über Hebel 93, die Drehpunkte auf dem Längsträger 85 oder auf dem Schwenkhebel 33 haben, durch pneumatische Zylinder 94 an die Walzen 30 angedrückt werden.

Wenn mit größeren Dickenunterschieden der Platten 1, 1a, 1b, 1c zu rechnen ist, können auch beide Walzen 30 mit den ihnen zugeordneten Düsen 38 auf Schwenkhebeln 33 angeordnet sein und gleichmäßig, elastisch an die Platten angedrückt werden. Es können Platten 1, 1a, 1b, lc mit unterschiedlich großen Oberflächen beschichtet werden, da die Beschichtungsmasse aus der Düse 38 nur in zuvor entleerte Vertiefungen der Walzenoberfläche 72 abgegeben wird.

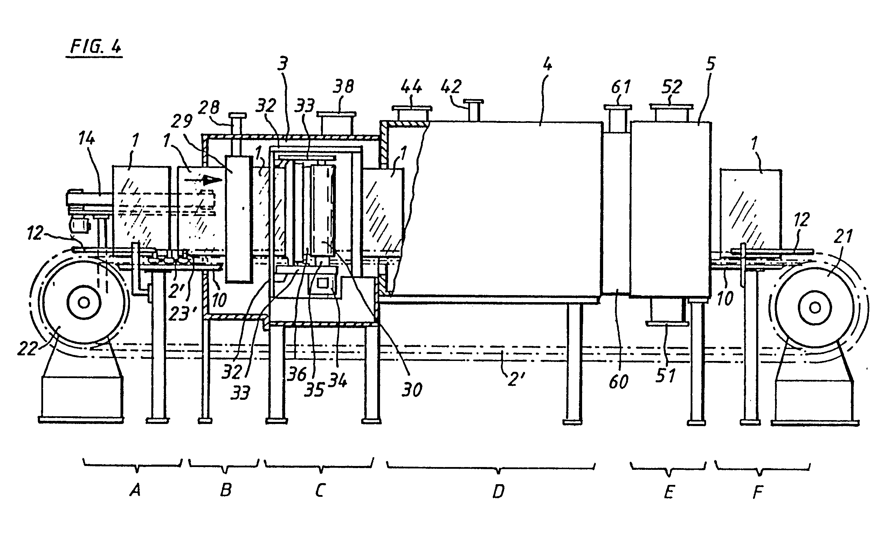

Die in Figur 4 gezeigte Vorrichtung enthält etwa die gleichen Behandlungseinrichtungen wie die Vorrichtung nach Figur 1, aber die Förderkette 2' verläuft unterhalb des Weges der Platten 1. Diese Anordnung schließt die Gefahr aus, daß an der Förderkette 2' haftende Staubpartikel auf die beschichteten Oberflächen fallen, bevor die Beschichtung getrocknet ist. Die Platten 1 werden auf Greifern 23' stehend transportiert. Eine Vielzahl von Greifern 23' befindet sich an der Förderkette 2', welche von einer Führungsschiene 10 unterstützt wird.

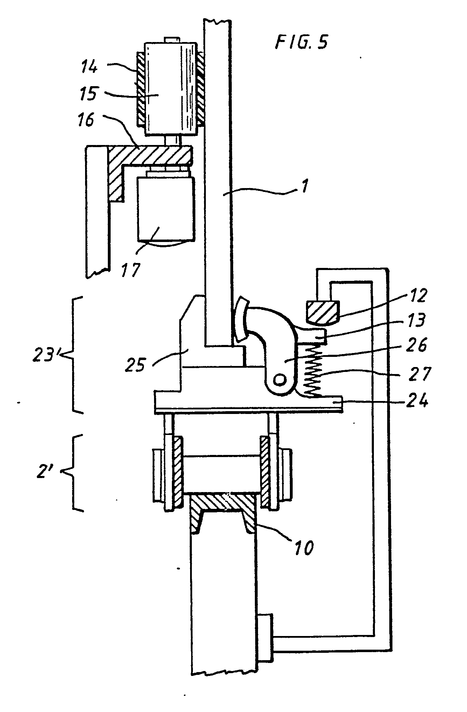

Wie auch in Figur 5 gezeigt ist, ist wenigstens in der Aufnahmestation A seitlich ein Abstützungsband 14 vorgesehen, das die Platten 1 seitlich unterstützt, bis sie durch die Greifer 23' ausreichend festgehalten werden, und das sich bis an die Entstaubungsstation B erstreckt. Das Band 14 läuft über Rollen 15, die von einem Motor 17 angetrieben werden und die auf einer Schiene 18 angebracht sind.

Die Greifer 23' gemäß Figur 5 bestehen aus einem Basisteil 24, einem Winkel 25 zur Unterstützung der Platten 1 in lotrechter Stellung, einem Klemmhebel 28 und einer Druckfeder 27, die den Klemmhebel 28 gegen die Platte 1 drückt. Der Klemmhebel 28 hat einen Finger 13. Eine Führungsschiene 12 ist so geformt, daß sie in der Aufnahmestation A und in der Abgabestation F den Klemmhebel 28 für das Einsetzen und die Entnahme der Platten 1 öffnet.

Wenn eine zweite Beschichtung erwünscht ist, kann eine weitere Auftragsstation mit einer weiteren Trocknungszone und Kühlzone folgen, wobei die Förderkette durch alle Stationen und Zonen kontinuierlich läuft. Die in der Abgabestatioh F mechanisch oder von Hand zu entnehmenden beschichteten Platten sind in jedem Falle trocken und können bei entsprechend langer Behandlung auch ausgehärtete Beschichtunge besitzen.

Die Erfindung ist nicht auf die Beschichtung bei Leiterplatten beschränkt, und änderungen beschriebener Einzelheiten sind im Rahmen der Erfindung möglich. Während für stehend transportierte Platten eine gewisse Steifigkeit der Platten notwendig ist, wozu bei Grundplatten für Leiterplatten auch die vorher aufgetragenen Kupferschichten beitragen, ist bei hängendem Transport die Steifigkeit von geringerer Bedeutung, so daß auch Platten von weniger als 0,1 mm Dicke behandelt werden können.

**Patentansprüche**

1. Verfahren zum Auftragen einer Beschichtung auf eine Mehrzahl dünner, steifer Platten mittels Auftragswalzen, wobei die Platten hintereinander kontinuierlich in horizontaler Richtung durch wenigstens eine Auftragsstation und eine anschließende Trocknungszone hindurch transportiert und dort behandelt werden, dadurch gekennzeichnet, daß die Platten in eine lotrechte Stellung gebracht und in dieser Stellung an einer zur Transportrichtung. parallelen Referenzleiste, die sich entlang eines Randes jeder Platte erstreckt, zum Zwecke des Transports festgehalten werden, und daß an jeder Stelle des Weges der Platten Druck und Erwärmung auf die beiden vertikalen Oberflächen der Platten von beiden Seiten des Weges symmetrisch wirken.

2. Verfahren nach Anspruch 1, dadurch gekennzeichnet, daß beim Durchlaufen der Auftragsstation und der Trocknungszone die Oberflächen aufeinanderfolgender Platten sich in derselben Ebene befinden.

3. Verfahren nach Anspruch 2, dadurch gekennzeichnet, daß die Platten die Auftragsstation und die Trocknungszone stehend durchlaufen, wobei sich die Referenzleiste, an der die Platten gehalten werden, an der unteren Kante der Platten befinden.

4 Verfahren nach einem der Ansprüche 1 bis 3, dadurch gekennzeichnet, daß eine temperierte, flüssige Beschichtungsmasse, insbesondere ein für die Herstellung von Leiterplatten verwendbarer Fotolack, mit einer Schichtdicke von etwa 4μm bis 8μm einseitig oder gleichzeitig auf beide Seiten aufgetragen wird.

5. Vorrichtung zum Auftragen einer Beschichtung auf eine Mehrzahl dünner, steifer Platten, die an einem Rand mit einer unbeschichtet bleibenden, zur Transportrichtung parallelen Referenzleiste versehen sind, nach einem Verfahren gemäß einem der Ansprüche 1 bis 4, mit einer Auftragsstation mit wenigstens einer Auftragswalze, deren Oberfläche mit elastisch deformierbaren Vertiefungen, vorzugsweise in Form von Gewindegängen, versehen ist, dadurch gekennzeichnet, daß eine kontinuierlich umlaufende Transportkette (2) mit Greifern (23) zum Erfassen der Referenzleisten und Halten der Platten (1) in lotrechter Stellung vorgesehen ist und von einer Aufnahmestation (A), durch eine Auftragsstation (C) und eine Trocknungszone (D) zu einer Abgabestation (F) in horizontaler Richtung verläuft, in der Auftragsstation (C) beiderseits der Transportkette (2) um lotrechte Achsen (35) drehdare Walzen mit elastischen Oberflächen angeordnet sind, von denen wenigstens eine eine mit deformierbaren Vertiefungen versehene Auftragswalze (30) ist, und an der Auftragswalze (30) eine Düse (36) zur Zuführung der Beschichtungsmasse anliegt, die mit einem lotrechten, über die Länge der Auftragswalze (30) reichenden Abgabeschlitz (74) versehen ist.

6. Vorrichtung nach Anspruch 5, dadurch gekennzeichnet, daß zur Dosierung der auf die Auftragswalze (30) abzugebenden Menge der Beschichtungsmasse die Düsenlippen (71, 72) beiderseits des Abgabeschlitzes (74) der Düse (36) unter örtlicher Verformung der elastischen Oberfläche (70) an die Auftragswalze (30) andrückbar sind.

7. Vorrichtung nach Anspruch 6, daduch gekennzeichnet, daß der Druck der Beschichtungsmasse, die der Düse (36) zugeführt wird, regelbar ist.

8. Vorrichtung nach einem der Ansprüche 1 bis 7, dadurch gekennzeichnet, daß die Greifer (23) der Transportkette (2) die an den Platten (1) befind-liche Referenzleiste erfassen und die Platten (1) in lotrechter Stellung hängend halten können.

9. Vorrichtung nach einem der Ansprüche 5 bis 7, dadurch gekennzeichnet, daß die Transportkette (2) unterhalb der Platten (1) verläuft und die Greifer (23) die unten an den Platten (1) befindlichen Referenzleisten erfassen und die Platten (1) in lotrechter Stellung stehend halten können.

10. Vorrichtung nach einem der Ansprüche 5 bis 9 mit in der Trocknungszone (D) angeordneten Düsen für ein trockenes gasförmiges Medium, dadurch gekennzeichnet, daß gleichartige Düsen (41) beiderseits des Weges der Platten (1) in symmetrischer Anordnung angebracht sind.

11. Vorrichtung nach Anspruch 10 mit in der Trocknungszone angeordneten Wärmestrahlern, dadurch gekennzeichnet, daß die Wärmestrahler (45), insbesondere Infrarotstrahler, beiderseits des Weges der Platten (1) in symmetrischer Anordnung angebracht sind. 12. Vorrichtung nach einem der Ansprüche 5 bis 11 mit einzelnen Kammern für die Behandlung der Platten, dadurch gekennzeichnet, daß eine die Trocknungszone (D) enthaltende Kammer (4) unmittelbar an eine die Auftragsstation (C) enthaltende Kammer (3) anschließt und an der die Trocknungszone enthaltenden Kammer (4) eine Einrichtung (44) zum Abführen von Luft sowie an den benachbarten Kammern (3, 60) Zuleitungen (38, 61) für staubfreie Luft angeordnet sind.

**Claims**

1. Method for the application of a coating onto a plurality of thin stiff plates by means of applicator rollers, wherein the plates are transported one behind the other continuously in horizontal direction through at least one applicator station and a drying zone and are treated there, characterised thereby, that the plates are brought into a perpendicular setting and held fast for the purpose of the transport in this setting at a reference strip, which is parallel to the transport direction and extends along an edge of each plate, and that pressure and heating act at every point of the path of the plates symmetrically from both sides of the path onto both the vertical surfaces of the plates.

2. Method according to claim 1, characterised thereby, that the surfaces of successive plates are disposed in the same plane during passage through the applicator station and the drying zone.

3. Method according to claim 2, characterised thereby, that the plates pass upright through the applicator station and the drying zone, while the reference strips, at which the plates are held, are disposed at the lower edge of the plates.

4. Method according to one of the claims 7 to 3, characterised thereby, that a liquid coating mass, in particular a photo-lacquer usable for the production of conductor boards, at appropriate temperature is applied in a layer thickness of about 4 micrometres to 8 micrometres onto one side or onto both sides at the same time.

5. Apparatus for the application of a coating onto a plurality of thin stiff plates, which are provided at one edge with a reference strip, which is parallel to the transport direction and remains uncoated, by a method according to one of the claims 1 to 4, with an applicator station with at least one applicator roller, the surface of which is provided with elastically deformable depressions, preferably in the shape of thread courses, characterised thereby, that a continuously circulating transport chain (2) with grippers (23) for the seizing of the reference strips and holding of the plates (1) in perpendicular setting is provided and extends in horizontal direction from a receiving station (A) through an applicator station (C) and a drying zone (D) to a delivery station (F), that rollers, which are rotatable about perpendicular axes (35) and of which at least one is an applicator roller (30) provided with deformable depressions, with elastic surfaces are arranged to both sides of the transport chain (2) in the applicator station (C) and that a nozzle (38), which is provided with a perpendicular delivery slot (74) reaching over the length of the applicator roller (30), for the feeding of the coating mass lies against the applicator roller (30).

6. Apparatus according to claim 5, characterised thereby, that for the metering of the quantity of the coating mass to be delivered onto the applicator roller (30), the nozzle lips (71, 72) at both sides of the delivery slot (74) of the nozzle (38) are pressable against the applicator roller (30) with local deformation of the elastic surface (70).

7. Apparatus according to claim 8, characterised thereby, that the pressure of the coating mass, which is fed to the nozzle (38), is regulable.

8. Apparatus according to one of the claims 1 to 7, characterised thereby, that the grippers (23) of the transport chain (2) can seize the reference strip disposed at the plates (7) and hold the plates (1) hanging in perpendicular setting.

9. Apparatus according to one of the claims 5 to 7, characterised thereby, that the transport chain (2) extends underneath the plates (1) and the grippers can seize the reference strip disposed at the bottom of the plates (1) and hold the plates (1) standing in perpendicular setting.

10. Apparatus according to one of the claims 5 to 9 with nozzles arranged in the drying zone (D) and for a dry gaseous medium, characterised thereby, that nozzles (47) of like kind are mounted in symmetrical arrangement to both sides of the path of the plates (7).

11. Apparatus according to claim 70 with heat radiators arranged in the drying zone, characterised thereby, that the heat radiators (45), in particular infra-red radiators, are mounted in symmetrical arrangement to both sides of the path of the plates (1).

12. Apparatus according to one of the claims 5 to 11 with individual chambers for the treatment of the plates, characterised thereby, that a chamber (4) containing the drying zone (D) adjoins directly at a chamber (3) containing the applicator station (C) and an equipment (44) for the removal of air is arranged at the chamber (4) containing the drying zone as well as feed ducts (38, 61) for dust-free air being arranged at the neighbouring chamber (3, 60).

**Revendications**

1. Procédé pour appliquer une couche sur une multiplicité de plaques rigides minces au moyen de cylindres enducteurs, dans lequel les plaques sont transportées les unes derrière les autres en continu, dans la direction horizontale, en passant par au moins une station d'enduction et une zone de séchage consécutive dans lesquelles elles sont traitées, caractérisé en ce que les plaques sont amenées dans une position verticale et retenues fixement dans cette position en vue du transport par une réglette de référence qui est parallèle a la direction de transport et qui s'étend le long d'un bord de chaque plaque et en ce qu'à tout emplacement du trajet des plaques, une pression et un chauffage sont appliqués symétriquement sur les deux surfaces verticales des plaques de part et d'autre du trajet.

2. Procédé selon la Revendication 1, caractérisé en ce qu'au cours du passage dans la station d'enduction et dans la zone de séchage, les surfaces des plaques successives se trouvent dans le même plan.

3. Procédé selon la Revendication 2, caractérisé en ce que les plaques parcourent la station d'enduction et la zone de séchage en position debout, les réglettes de référence contre lesquelles les plaques sont maintenues, se trouvant contre 1'arête inférieure des plaques.

4. Procédé selon l'une des Revendication 1 à 3, caractérisé en ce que l'on applique une masse d'enduction fluide, amenée à une température modérée, en particulier un vernis photosensible utilisable pour la fabrication des plaquettes à circuits imprimés, avec une épaisseur de couche d'environ 4μm à 8 μm, d'un seul côté ou sur les deux côtés simultanément.

5. Dispositif pour appliquer une couche sur une multiplicité de plaques rigides minces, qui sont pourvues sur un bord d'une réglette de référence qui est parallèle à la direction de transport et qui demeure non revêtue, conformément à un procédé selon l'une quelconque des Revendication 1 à 4, dispositif comportant une station d'enduction ayant au moins un cylindre d'enduction dont la surface présente des creux deformables élastiquement, de préférence sous la forme de pas de vis, et caractérisé en ce qu'il comprend une chaîne transporteuse (2) en rotation continue, comportant des griffes (23) destinées à saisir les réglettes de référence et à maintenir les plaques (1) en position verticale, cette chaîne circulant dans la direction horizontale d'une station de réception (A) à une station de délivrance (F) en passant par une station d'enduction (C) à une zone de séchage (D), dans la station d'enduction (C) étant montés de part et d'autre de la chaîne transporteuse (2) autour d'axes verticaux (35) des cylindres rotatifs ayant des surfaces élastiques, dont au moins l'un est un cylindre d'enduction (30) pourvu de creux déformables, et en ce que sur le cylindre d'enduction (30) est ajustée une buse (36) qui est destinée à l'admission de la masse d'enduction et qui est pourvue d'une fente de distribution (74) verticale s'étendant sur toute la longueur du cylindre d'enduction (30).

6. Dispositif selon la Revendication 5, caractérisé en ce que pour le dosage de la quantité de masse d'enduction à déposer sur le cylindre enducteur (30), les lèvres (71,72) présentées de part et d'autre de la fente de distribution (74) de la buse (36) sont compressibles contre le cylindre enducteur (30) sous déformation locale de la surface élastique 71) dudit cylindre.

7. Dispositif selon la Revendication 6, caractérisé en ce que la pression de la masse d'enduction qui est admise dans la buse (36), est réglable.

8. Dispositif selon l'une des Revendications 1 à 7, caractérisé en ce que les griffes (23) de la chaîne transporteuse (2) peuvent saisir les réglettes de référence se trouvant sur les plaques (1) et peuvent maintenir les plaques (1) suspendues en position verticale.

9. Dispositif selon l'une des Revendications 5 à 7, caractérisé en ce que la chaîne transporteuse (2) circule au-dessous des plaques (1) et en ce que les griffes (23) peuvent saisir les réglettes de référence se trouvant à la partie inférieure des plaques (1) et peuvent maintenir les plaques (1) suspendues en position verticale.

10. Dispositif selon l'une des Revendication 5 à 9 comportant des tuyères disposées dans la zone de séchage (D) pour l'admission d'un milieu gazeux sec, caractérisé en ce que des tuyères (41) identiques sont montées en disposition symétrique de part et d'autre du trajet des plaques (1).

11. Dispositif selon la Revendication 10 comportant des radiateurs de chaleur disposés dans la zone de séchage, caractérisé en ce que les radiateurs de chaleur (45), en particulier des radiateurs d'infrarouge, sont montés en disposition symétrique de part et d'autre du trajet des plaques (1).

12. Dispositif selon l'une des Revendication 5 à 11 comportant des chambres individuelles pour le traitement des plaques, caractérisé en ce qu'une chambre (4) renfermant la zone de séchage (D) est immédiatement adjacente à une chambre (3) renfermant la station d'enduction (C) et en ce que sur la chambre (4) renfermant la zone de séchage est prévu un dispositif (44) pour 1' évacuation de l'air, de même que sur les chambres (3, 60) contigues sont disposés des conduits (38, 61) pour l'admission d'air exempt de poussière.

FIG.1

FIG.3

82
92
86
81
84  94  33  35  30  87
36

94  92  91  88 89 90  30  85  81
93
88 89
83
82
84
87
82
32  93  94  33  36  30  70 71 72  86  81  32
70 71 72

FIG. 2

FIG. 4

0 081 830

FIG. 5